(19)

**Europäisches Patentamt**
**European Patent Office**
**Office européen des brevets**

(11) **EP 4 636 981 A1**

(12) **EUROPEAN PATENT APPLICATION**
published in accordance with Art. 153(4) EPC

(43) Date of publication:
**22.10.2025 Bulletin 2025/43**

(21) Application number: 23928265.0

(22) Date of filing: **15.08.2023**

(51) International Patent Classification (IPC):
***H02J 7/00*** (2006.01)

(86) International application number:
**PCT/CN2023/113178**

(87) International publication number:
**WO 2024/192960 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.03.2023 CN 202310280596**

(71) Applicant: **Hefei Gotion High-Tech Power Energy
Co., Ltd.
Hefei, Anhui 230012 (CN)**

(72) Inventors:
 • **LU, Kai**
  **Hefei, Anhui 230012 (CN)**
 • **WANG, Xinxin**
  **Hefei, Anhui 230012 (CN)**
 • **CHENG, Qianqian**
  **Hefei, Anhui 230012 (CN)**

(74) Representative: **Studio Torta S.p.A.
Via Viotti, 9
10121 Torino (IT)**

(54) **POWER CONTROL METHOD AND APPARATUS, ENERGY STORAGE SYSTEM, AND NONVOLATILE STORAGE MEDIUM**

(57)   Disclosed are a power control method and apparatus, an energy storage system, and a nonvolatile storage medium. The method includes: acquiring a State of Charge (SOC) of each of a plurality of battery cells in the energy storage system, and a power direction and a power level of a microgrid connected to the energy storage system; determining, according to the SOC of each of the plurality of battery cells and the power direction of the microgrid, an optimal cell power of each of the plurality of battery cells matching the power direction of the microgrid, and a maximum cell power of each of the plurality of battery cells matching the power direction of the microgrid; determining total optimal power and total maximum power of the plurality of battery cells according to the optimal cell power and the maximum cell power; and determining an actual cell power of each of the plurality of battery cells according to the total optimal power, the total maximum power, and the power level of the microgrid.

Fig. 2

A SOC of each of a plurality of battery cells in an energy storage system, and a power direction and a power level of a microgrid connected to the energy storage system are acquired, wherein the power direction of the microgrid includes a charging direction or a discharging direction — S202

An optimal cell power of each of the plurality of battery cells matching the power direction of the microgrid, and a maximum cell power of each of the plurality of battery cells matching the power direction of the microgrid are determined according to the SOC of each of the plurality of battery cells and the power direction of the microgrid — S204

A total optimal power and a total maximum power of the plurality of battery cells are determined according to the optimal cell power of each of the plurality of battery cells and the maximum cell power of each of the plurality of battery cells — S206

An actual cell power of each of the plurality of battery cells is determined according to the total optimal power and the total maximum power of the plurality of battery cells, and the power level of the microgrid — S208

**EP 4 636 981 A1**

## Description

The present disclosure claims priority to Chinese Patent Application No. 2023102805964, filed on March 17, 2023 and entitled "Power Control Method and Apparatus, Energy Storage System, and Nonvolatile Storage Medium", the disclosure of which is hereby incorporated by reference in its entirety.

## Technical Field

The present disclosure relates to the field of battery energy storage, and in particular, to a power control method and apparatus, an energy storage system, and a nonvolatile storage medium.

## Background

An energy storage system refers to a system that stores energy in forms such as electric energy through different media and releases the energy as needed. The energy storage system may be composed of a plurality of energy storage containers, each of which contains a battery cell, a Battery Management System (BMS) for monitoring battery status information, and a Power Conversion System (PCS) for converting a direct current generated by a battery and an alternating current required by the microgrid, and may further include a cooling system, a fire protection system, a lighting and monitoring system, etc.

During the charging and discharging processes of the current energy storage system, the power input and output of the battery cell are controlled by the PCS, and the PCS responds to the power demand on a power grid side or a microgrid side, and distributes the power demand as evenly as possible to each PCS on the premise that the power does not exceed the maximum tolerable power of the battery cell, so as to charge and discharge each battery cell.

According to an energy storage system and an energy balancing control method thereof, as well as a photovoltaic and storage integrated multi-machine parallel system disclosed in the patent application CN202011322379.X, SOC balancing is achieved using a method of determining an average value of States of Charge (SOCs) of the batteries, and determining a balanced current according to a difference between the SOC of each battery module and the average value of the SOCs. However, this method is mostly applicable to the energy storage system in a static state, the average value of the SOCs in the charging and discharging states changes in real time, and a method of superimposing the balanced current during the charging and discharging processes of a DC converter is extremely complicated. At the same time, this balancing method does not fully consider the characteristics of the battery, that is, when the capacity of the battery is reduced, it is very likely that there is a deterioration of a battery cell inside the battery, referred to as a short-board battery, and frequent charging of the short-board battery further reduces the service life of the short-board battery. The above process is not intelligent for a power distribution process of battery charging and discharging in the energy storage system, and there are many problems.

For the above problems, no effective solution has yet been proposed.

## Summary

Embodiments of the present disclosure provide a power control method and apparatus, an energy storage system, and a nonvolatile storage medium, so as to at least solve the technical problem that a distribution of battery power is not intelligent when controlling charging and discharging of each battery cell in the energy storage system.

According to one aspect of the embodiments of the present disclosure, a power control method is provided, which includes: acquiring a SOC of each of a plurality of battery cells in an energy storage system, and a power direction and a power level of a microgrid connected to the energy storage system, where the power direction of the microgrid includes a charging direction or a discharging direction; determining, according to the SOC of each of the plurality of battery cells and the power direction of the microgrid, an optimal cell power of each of the plurality of battery cells matching the power direction of the microgrid, and a maximum cell power of each of the plurality of battery cells matching the power direction of the microgrid; determining a total optimal power and a total maximum power of the plurality of battery cells according to the optimal cell power of each of the plurality of battery cells and the maximum cell power of each of the plurality of battery cells; and determining an actual cell power of each of the plurality of battery cells according to the total optimal power and the total maximum power of the plurality of battery cells, and the power level of the microgrid.

As at least one alternative embodiment, the operation of determining, according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid includes: in a case where the power direction of the microgrid is that the microgrid delivers electric energy to the energy storage system, calling an optimal charging power curve of each of the plurality of battery cells and a maximum charging power curve of each of the plurality of battery cells; determining an optimal charging power of each of the plurality of battery cells and the maximum charging power of each of the plurality of battery cells, according to the optimal charging power curve of each of the plurality of battery cells, the maximum charging power curve of each of the plurality of battery cells, and the SOC of each battery cell, wherein the optimal cell power includes the optimal charging power, and the maximum cell power includes the maximum charging power; in a case where the power direction of the microgrid is that the energy storage system delivers the electric energy to the microgrid, calling an optimal discharging power curve of each of the plurality of battery cells and a maximum discharging power curve of each of the plurality of battery cells; and determining the optimal discharging power of each of the plurality of battery cells and the maximum discharging power of each of the plurality of battery cells, according to the optimal discharging power curve of each of the plurality of battery cells, the maximum discharging power curve of each of the plurality of battery cells, and the SOC of each battery cell, wherein the optimal cell power includes the optimal discharging power, and the maximum cell power includes the maximum discharging power.

As at least one alternative embodiment, in a case where the power direction of the microgrid is that the microgrid delivers the electric energy to the energy storage system, the operation of determining actual cell power of each of the plurality of battery cells according to the total optimal power and the total maximum power of the plurality of battery cells, and the power level of the microgrid includes: in a case where the power level of the microgrid is less than the total optimal charging power of the plurality of battery cells, dividing the power level of the microgrid by the total optimal charging power of the plurality of battery cells to obtain a first ratio, where the total optimal charging power of the plurality of battery cells is the sum of the optimal charging power of each of the plurality of battery cells; and multiplying the optimal charging power of each of the plurality of battery cells by the first ratio to obtain the actual cell power of each of the plurality of battery cells.

As at least one alternative embodiment, in a case where the power level of the microgrid is greater than the total optimal charging power of the plurality of battery cells and less than the total maximum charging power of the plurality of battery cells, dividing the power level of the microgrid by the total maximum charging power of the plurality of battery cells to obtain a second ratio, where the total maximum charging power of the plurality of battery cells is the sum of the maximum charging power of each of the plurality of battery cells; multiplying the optimal charging power of each of the plurality of battery cells by the second ratio to obtain the actual cell power of each of the plurality of battery cells; and in a case where the power level of the microgrid is greater than the total maximum charging power of the plurality of battery cells, taking the maximum charging power of each of the plurality of battery cells as the actual cell power of each of the plurality of battery cells.

As at least one alternative embodiment, in a case where the power direction of the microgrid is that the energy storage system delivers the electric energy to the microgrid, the operation of determining the actual cell power of each of the plurality of battery cells according to the total optimal power and the total maximum power of the plurality of battery cells, and the power level of the microgrid includes: determining a total SOC of the plurality of battery cells according to the SOC of each of the plurality of battery cells; in a case where the power level of the microgrid is less than the total optimal discharging power of the plurality of battery cells, dividing the SOC of each of the plurality of battery cells by the total SOC of the plurality of battery cells to obtain a third ratio, where the total optimal discharging power of the plurality of battery cells is the sum of the optimal discharging power of each of the plurality of battery cells; and multiplying the power level of the microgrid by the third ratio to obtain the actual cell power of each of the plurality of battery cells.

As at least one alternative embodiment, in a case where the power level of the microgrid is greater than the total optimal discharging power of the plurality of battery cells and less than the total maximum discharging power of the plurality of battery cells, dividing the power level of the microgrid by the total maximum discharging power of the plurality of battery cells to obtain a fourth ratio, where the total maximum discharging power of the plurality of battery cells is the sum of the maximum discharging power of each of the plurality of battery cells; multiplying the optimal discharging power of each of the plurality of battery cells by the fourth ratio to obtain the actual cell power of each of the plurality of battery cells; and in a case where the power level of the microgrid is greater than the total maximum discharging power of the plurality of battery cells, taking the maximum discharging power of each of the plurality of battery cells as the actual cell power of each of the plurality of battery cells.

According to another aspect of the embodiments of the present disclosure, a power control apparatus is further provided, which includes: an acquisition module, configured to acquire the SOC of each of a plurality of battery cells in an energy storage system, and a power direction and a power level of a microgrid connected to the energy storage system, where the power direction of the microgrid includes a charging direction or a discharging direction; a first determination module, configured to determine, according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid; a second determination module, configured to determine a total optimal power and a total maximum power of the plurality of battery cells according to the optimal cell power of each of the plurality of battery cells and the maximum cell power of each of the plurality of battery cells; and a third determination module, configured to determine the actual cell power of each of the plurality of battery cells according to the total optimal power and the total maximum power of the plurality of battery cells, and the power level of the microgrid.

According to another aspect of the embodiments of the present disclosure, an energy storage system is further provided, which includes: a Microgrid Controller (MC), a plurality of energy storage units, and an electric meter, where one end of the electric meter is connected to a microgrid, and the other end is connected to the MC to inform the MC of a power direction and a power level of the microgrid. Each of the plurality of energy storage units includes a battery cell, a BMS, and a PCS. The MC is configured to perform any one of the above power control methods to control the actual cell power of each of the plurality of battery cells included in the plurality of energy storage units.

According to yet another aspect of the embodiments of the present disclosure, a nonvolatile storage medium is further provided, which includes a stored program. The program, when running, controls a device where the nonvolatile storage medium is located to perform any one of the above power control methods.

According to still another aspect of the embodiments of the present disclosure, a computer device is further provided, which includes a memory and a processor. The memory is configured to store a program, and the processor is configured to run the program stored in the memory. The program, when running, performs any one of the above power control methods.

In the embodiments of the present disclosure, a method of reasonably estimating the total optimal power and the total maximum power of the plurality of battery cells in the energy storage system is used. By determining the actual cell power of each of the plurality of battery cells according to the total optimal power and the total maximum power of the plurality of battery cells, and the power level of the microgrid, the purpose of determining the actual power of each battery in the energy storage system in response to the demand of the microgrid according to the actual state of each battery in the energy storage system and the actual power state of the microgrid is achieved, thereby achieving the technical effect of improving the intelligent level of power distribution between each battery cell in the energy storage system and the microgrid during charging and discharging, and further solving the technical problem that the distribution of the battery power is not intelligent when controlling charging and discharging of each battery cell in the energy storage system.

**Brief Description of the Drawings**

The drawings described herein are used to provide a further understanding of the present disclosure, and constitute a part of the present disclosure, and the exemplary embodiments of the present disclosure and the description thereof are used to explain the present disclosure, but do not constitute improper limitations to the present disclosure. In the drawings:

Fig. 1 shows a block diagram of a hardware structure of a computer terminal for implementing a power control method.

Fig. 2 is a schematic flowchart of a power control method according to an embodiment of the present disclosure.

Fig. 3 is a structural block diagram of an energy storage system according to an embodiment of the present disclosure.

Fig. 4 is a schematic structural diagram of an energy storage system according to an optional embodiment of the present disclosure.

Fig. 5 is a flowchart of a battery power control method according to an optional embodiment of the present disclosure.

Fig. 6 is a structural block diagram of a power control apparatus according to an embodiment of the present disclosure.

**Detailed Description of the Embodiments**

In order to make the solutions of the present disclosure understood by those skilled in the art, the technical solutions in the embodiments of the present disclosure will be clearly and completely described below in combination with the drawings in the embodiments of the present disclosure. It is apparent that the described embodiments are not all embodiments but only part of embodiments of the present disclosure. All other embodiments obtained by those of ordinary skill in the art on the basis of the embodiments in the present disclosure without creative work shall fall within the scope of protection of the present disclosure.

It is to be noted that terms "first", "second" and the like in the description, claims and the above drawings of the present disclosure are used for distinguishing similar objects rather than describing a specific sequence or a precedence order. It should be understood that the data used in such a way may be exchanged where appropriate, in order that the embodiments of the present disclosure described here may be implemented in an order other than those illustrated or described herein. In addition, terms "include" and "have" and any variations thereof are intended to cover non-exclusive inclusions. For example, it is not limited for processes, methods, systems, products or devices containing a series of steps or units to clearly list those steps or units, and other steps or units which are not clearly listed or are inherent to these processes, methods, products or devices may be included instead.

According to the embodiments of the present disclosure, an embodiment of a power control method is provided. It is to be noted that the steps shown in the flowchart of the drawings may be executed in a computer system, such as a set of computer-executable instructions, and although a logical sequence is shown in the flowchart, in some cases, the steps shown or described may be executed in a different order than here.

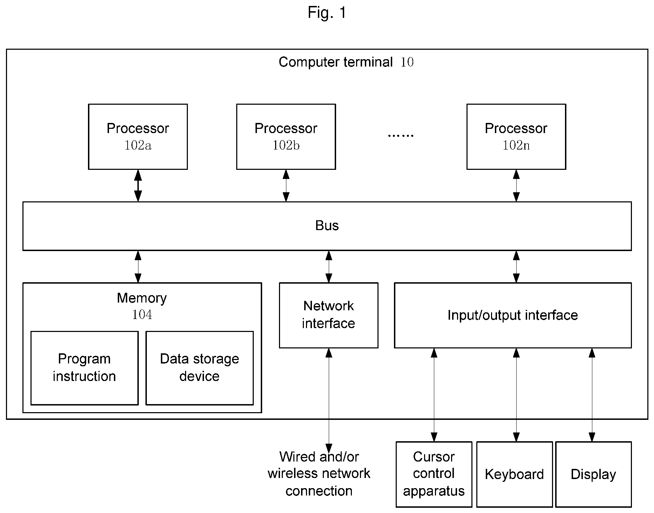

The method embodiment provided by Embodiment 1 of the present disclosure may be implemented in a mobile terminal, a computer terminal or a similar computing apparatus. Fig. 1 shows a block diagram of a hardware structure of a computer terminal for implementing a power control method. As shown in Fig. 1, a computer terminal 10 may include one or more (shown as 102a, 102b, ..., 102n in the figure) processors (the processors may include, but are not limited to, a processing apparatus such as a Micro Controller Unit (MCU) or a Field Programmable Gate Array (FPGA)) and a memory 104 configured to store data. In addition, the above computer terminal may further include: a display, an Input/Output interface (I/O interface), a Universal Serial Bus (USB) port (which may be included as one of ports of a BUS bus), a network interface, a power supply, and/or a camera. Those of ordinary skill in the art may understand that the structure shown in Fig. 1 is merely illustrative, and does not limit the structure of the above electronic apparatus. For example, the computer terminal 10 may further include more or fewer components than shown in Fig. 1, or has a different configuration from that shown in Fig. 1.

It is to be noted that one or more processors and/or other data processing circuits may be generally referred to herein as "data processing circuits". The data processing circuit may be embodied in whole or in part as software, hardware, firmware, or any other combination. Further, the data processing circuit may be a single and stand-alone processing module, or combined in whole or in part into any of other elements of the computer terminal 10. As referred to in the embodiments of the present disclosure, the data processing circuit acts as a processor control (such as selection of a variable resistance terminal path connected to the interface).

The memory 104 may be configured to store a software program and a module of application software, such as a program instruction/data storage apparatus corresponding to the power control method in the embodiments of the present disclosure, and the processor performs various functional applications and data processing by running the computer program and the module stored in the memory 104, that is, implements the above power control method for the application program. The memory 104 may include a high speed Random Access Memory (RAM) and may further include a nonvolatile memory such as one or more magnetic storage apparatuses, a flash memory, or other nonvolatile solid state memories. In some examples, the memory 104 may further include memories remotely located relative to the processor, which may be connected to the computer terminal 10 through a network. Examples of the above network include, but are not limited to, the Internet, the Intranet, a local area network, a mobile communication network, and a combination thereof.

The display may be, for example, a touch screen type Liquid Crystal Display (LCD) that enables a user to interact with a user interface of the computer terminal 10.

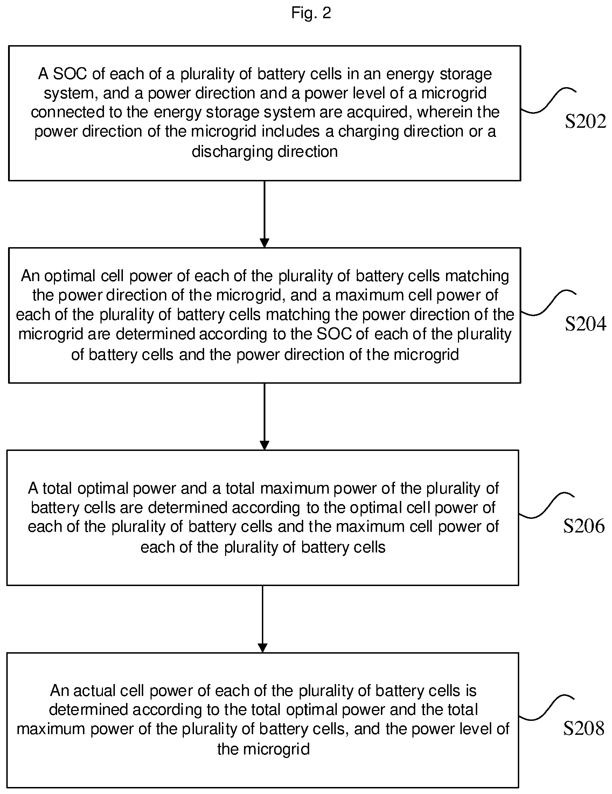

Fig. 2 is a schematic flowchart of a power control method according to an embodiment of the present disclosure, as shown in Fig. 2, the method includes the following steps.

At S202, an SOC of each of a plurality of battery cells in an energy storage system, and a power direction and a power level of a microgrid connected to the energy storage system are acquired, wherein the power direction of the microgrid includes a charging direction or a discharging direction.

The power direction of the microgrid is the charging direction, which may indicate that the microgrid requires to be charged by the energy storage system, that is, the energy storage system delivers electric energy to the microgrid. The power direction of the microgrid is the discharging direction, which may indicate that the microgrid may charge the energy storage system, that is, the microgrid delivers the electric energy to the energy storage system. In addition, the power level of the microgrid is a power value required for charging or discharging. As at least one alternative embodiment, a power value with a value range including positive and negative values may be selected to represent the power direction and the power level of the microgrid at the same time. For example, P may be used to represent the power direction and the power level of the microgrid. When P is greater than 0, it may indicate that the microgrid delivers the electric energy to the energy storage system. When P is less than 0, it may indicate that the energy storage system delivers the electric energy to the microgrid. An absolute value of P may represent the power level of the microgrid.

At S204, an optimal cell power of each of the plurality of battery cells matching the power direction of the microgrid, and a maximum cell power of each of the plurality of battery cells matching the power direction of the microgrid are determined according to the SOC of each of the plurality of battery cells and the power direction of the microgrid.

It is to be noted that a current SOC of a battery may affect a current performance of the battery, for example, it may affect a current optimal charging and discharging power of the battery and a current maximum charging and discharging power of the battery. The optimal charging and discharging power of the battery is the power used when the battery can operate normally and stably for a long time, while the maximum charging and discharging power of the battery is a current charging and discharge capacity limit of the battery. If the operating environment permits, the best arrangement is to prioritize the battery to operate at a power close to the optimal charging and discharging power.

As an optional embodiment, the operation that according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid are determined may include the following steps.

In a case where the power direction of the microgrid is that the microgrid delivers electric energy to the energy storage system, the optimal charging power curve of each of the plurality of battery cells and the maximum charging power curve of each of the plurality of battery cells are called; according to the optimal charging power curve of each of the plurality of battery cells, the maximum charging power curve of each of the plurality of battery cells, and the SOC of each battery cell, the optimal charging power of each of the plurality of battery cells and the maximum charging power of each of the plurality of battery cells are determined, wherein the optimal cell power includes the optimal charging power, and the maximum cell power includes the maximum charging power; in a case where the power direction of the microgrid is that the energy storage system delivers the electric energy to the microgrid, the optimal discharging power curve of each of the plurality of battery cells and the maximum discharging power curve of each of the plurality of battery cells are called; and according to the optimal discharging power curve of each of the plurality of battery cells, the maximum discharging power curve of each of the plurality of battery cells, and the SOC of each battery cell, the optimal discharging power of each of the plurality of battery cells and the maximum discharging power of each of the plurality of battery cells are determined, wherein the optimal cell power includes the optimal discharging power, and the maximum cell power includes the maximum discharging power.

It is to be noted that the optimal charging power curve, the maximum charging power curve, the optimal discharging power curve, and the maximum discharging power curve may be curve data built into an MC in advance, and the above curves may be obtained by performing actual charging and discharging tests on the plurality of battery cells in the energy storage system, so that the electrical characteristics of each battery cell in the energy storage system may be reflected. As at least one alternative embodiment, a horizontal coordinate of the above curve may be the current SOC of the battery, so that the current optimal charging power, maximum charging power, optimal discharging power, and maximum discharging power of each battery cell may be determined according to the current SOC of each battery cell.

At S206, a total optimal power and a total maximum power of the plurality of battery cells are determined according to the optimal cell power of each of the plurality of battery cells and the maximum cell power of each of the plurality of battery cells.

As at least one alternative embodiment, the optimal cell power may include the optimal discharging power and the optimal charging power of the battery cell.

The maximum cell power may include the maximum discharging power and the optimal discharging power of the battery cell.

At S208, an actual cell power of each of the plurality of battery cells is determined according to the total optimal power and the total maximum power of the plurality of battery cells, and the power level of the microgrid.

As at least one alternative embodiment, in a case where the power direction of the microgrid is that the microgrid delivers the electric energy to the energy storage system, S208 may be implemented in the following manner: in a case where the power level of the microgrid is less than the total optimal charging power of the plurality of battery cells, dividing the power level of the microgrid by the total optimal charging power of the plurality of battery cells to obtain a first ratio, wherein the total optimal charging power of the plurality of battery cells is the sum of the optimal charging power of each of the plurality of battery cells; and multiplying the optimal charging power of each of the plurality of battery cells by the first ratio to obtain the actual cell power of each of the plurality of battery cells.

The optimal charging power of each of the plurality of battery cells may be expressed as $p_i$, where the subscript i represents the serial number of each of the plurality of battery cells in the energy storage system, and the total optimal charging power of the plurality of battery cells may be expressed as $p_{total}$, $p_{total} = \sum_{i=1}^{n} p_i$, n represents the total number of the plurality of battery cells, the power level of the microgrid is P, and the first ratio is $P/p_{total}$. At this time, the actual cell power of each of the plurality of battery cells may be expressed as ($p_i$*$P/p_{total}$), and the actual cell power is the actual charging power of each battery cell.

As one optional embodiment, in a case where the power level of the microgrid is greater than the total optimal charging power of the plurality of battery cells and less than the total maximum charging power of the plurality of battery cells, the power level of the microgrid is divided by the total maximum charging power of the plurality of battery cells to obtain a second ratio, where the total maximum charging power of the plurality of battery cells is the sum of the maximum charging power of the plurality of battery cells; the optimal charging power of the plurality of battery cells is multiplied by the second ratio to obtain the actual cell power of each of the plurality of battery cells; and in a case where the power level of the microgrid is greater than the total maximum charging power of the plurality of battery cells, the maximum charging power of each of the plurality of battery cells is used as the actual cell power of each of the plurality of battery cells.

The second ratio may be expressed as $P/pmax_{total}$, $pmax_{total}$ represents the total maximum charging power of the plurality of battery cells,

$$pmax_{total} = \sum_{i=1}^{n} pmax_i$$ , and $pmax_i$ represents the maximum charging power of each of the plurality of battery cells. As at least one alternative embodiment, the actual cell power obtained by multiplying the optimal charging power of the plurality of battery cells by the second ratio may be expressed as (pi * P/pmax$_{total}$). In a case where the power of the microgrid is greater than the total maximum charging power, the pmax$_i$ of each of the plurality of battery cells is taken as the actual cell power.

As one optional embodiment, in a case where the power direction of the microgrid is that the energy storage system delivers the electric energy to the microgrid, the operation that actual cell power of each of the plurality of battery cells is determined according to the total optimal power and the total maximum power of the plurality of battery cells, and the power level of the microgrid may include the following steps: determining the total SOC of the plurality of battery cells according to the SOC of each of the plurality of battery cells; in a case where the power level of the microgrid is less than the total optimal discharging power of the plurality of battery cells, dividing the SOC of each of the plurality of battery cells by the total SOC of the plurality of battery cells to obtain a third ratio, wherein the total optimal discharging power of the plurality of battery cells is the sum of the optimal discharging power of each of the plurality of battery cells; and multiplying the power level of the microgrid by the third ratio to obtain the actual cell power of each of the plurality of battery cells.

The SOC of each of the plurality of battery cells may be expressed as SOC$_i$, wherein the subscript i represents the serial number of the battery cell, and the total SOC of the plurality of battery cells may be expressed as $$SOC_{total} = \sum_{i=1}^{n} SOC_i$$ . At this time, the total optimal discharging power of the plurality of battery cells may be expressed as p'$_{total}$, the optimal discharging power of each of the plurality of battery cells may be expressed as p'$_i$, and $$p'_{total} = \sum_{i=1}^{n} p'_i$$ . The third ratio may be expressed as SOC$_i$/SOC$_{total}$. Since the SOC of each battery cell is different, the third ratio may include a set of ratio numbers, and the number of ratio numbers is equal to the number n of battery cells in the energy storage system. The power P of the microgrid is multiplied by the third ratio to obtain the actual battery discharging power of each of the plurality of battery cells.

As one optional embodiment, in a case where the power level of the microgrid is greater than the total optimal discharging power of the plurality of battery cells and less than the total maximum discharging power of the plurality of battery cells, the power level of the microgrid is divided by the total maximum discharging power of the plurality of battery cells to obtain a fourth ratio, wherein the total maximum discharging power of the plurality of battery cells is the sum of the maximum discharging power of each of the plurality of battery cells; the optimal discharging power of each of the plurality of battery cells is multiplied by the fourth ratio to obtain the actual cell power of each of the plurality of battery cells; and in a case where the power level of the microgrid is greater than the total maximum discharging power of the plurality of battery cells, the maximum discharging power of each of the plurality of battery cells is used as the actual cell power of each of the plurality of battery cells.

The total maximum discharging power of the plurality of battery cells may be expressed as pmax'$_{total}$, and the maximum discharging power of each of the plurality of battery cells may be expressed as pmax'$_i$ and $$pmax'_{total} = \sum_{i=1}^{n} pmax'_i$$ . At this time, the fourth ratio may be expressed as P/pmax'$_{total}$, and the actual cell power of each of the plurality of battery cells may be expressed as (p'$_i$*P/pmax'$_{total}$). In a case where P is greater than pmax'$_i$, pmax'$_i$ is used as the actual cell discharging power of each of the plurality of battery cells.

Through the above steps, a method of reasonably estimating the total optimal power and the total maximum power of the plurality of battery cells in the energy storage system is used. By determining the actual cell power of each of the plurality of battery cells according to the total optimal power and the total maximum power of the plurality of battery cells, and the power level of the microgrid, the purpose of determining the actual power of each battery in the energy storage system in response to the demand of the microgrid according to the actual state of each battery in the energy storage system and the actual power state of the microgrid is achieved, thereby achieving the technical effect of improving the intelligent level of power distribution between each battery cell in the energy storage system and the microgrid during charging and discharging, and further solving the technical problem that the distribution of the battery power is not intelligent when controlling charging and discharging of each battery cell in the energy storage system. The above method and steps may be applied to the MC.

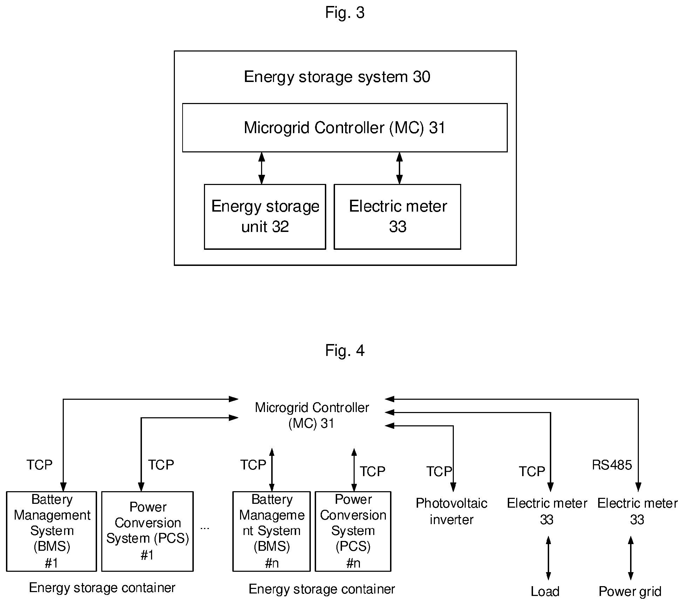

Fig. 3 is a structural block diagram of an energy storage system according to an embodiment of the present disclosure. As shown in Fig. 3, an energy storage system 30 includes: an MC 31, a plurality of energy storage units 32, and an electric meter 33. One end of the electric meter is connected to a microgrid, and the other end is connected to the MC to inform the MC of a power direction and a power level of the microgrid. Each of the plurality of energy storage units includes a battery cell, a BMS, and a PCS. The MC is configured to perform any one of the above power control methods to control actual cell power of each of the plurality of battery cells included in the plurality of energy storage units.

Fig. 4 is a schematic structural diagram of an energy storage system according to an optional embodiment of the present disclosure. As shown in Fig. 4, in each energy storage system, the charging and discharging situations of electric energy of an energy storage container are managed by the MC. The MC 31 may be connected to a load and a power grid through an electric meter 33, the load usually requires to be powered by the energy storage container, and the power grid may deliver the electric energy to the energy storage container. The n energy storage containers may be included, each of which includes a BMS and a PCS. The BMS is a secondary device in the energy storage container, and is configured to collect an electrical state of a battery cell in the energy storage container, such as an SOC of the battery cell, and transmit the SOC of the battery cell to the MC 31. The PCS is a primary device in the energy storage container, and is configured to control charging and discharging states of the battery cell, so that the MC 31 may send a control signal to the PCS to control actual cell power used by the battery cell in each energy storage container through the PCS. The plurality of energy storage containers are optional embodiments of the plurality of energy storage units 32.

As at least one alternative embodiment, the MC 31 may use an A8-arm processor, a moldbus-tcp protocol may be used between the MC 31 and the PCS, and an IEC104 protocol may be used between the MC 31 and the BMS for data transmission. A circuit breaker is arranged between the PCS and the power grid, and the MC is electrically connected to the circuit breaker. When the MC detects an abnormality in the battery cell through the BMS, the circuit breaker may immediately send a disconnection instruction to directly cut off the battery cell, and send a charging stop instruction to the PCS to protect the PCS.

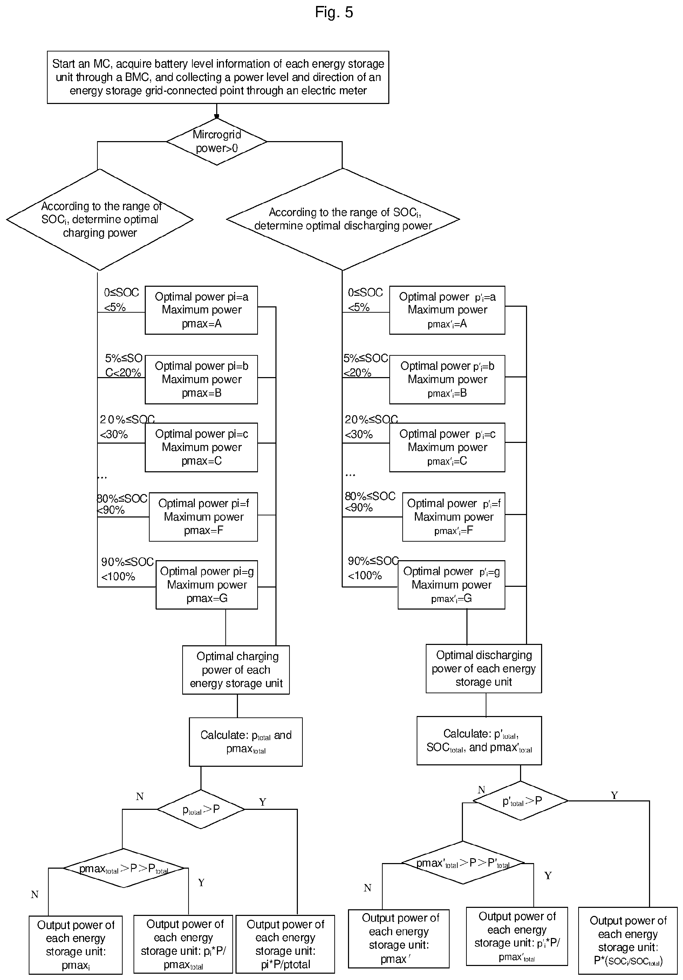

Fig. 5 is a flowchart of a battery power control method according to an optional embodiment of the present disclosure, as shown in Fig. 5, the method may include the following steps.

At S1, the MC is started, the MC collects a situation of an SOC of each battery cell through a BMS of each battery cell and numbers the SOCs as $SOC_i$ in sequence. The MC collects a current microgrid state through an electric meter, that is, the charging power required by a microgrid or excess power, that is, microgrid power P, so as to determine whether an energy storage system performs discharging or charging. The relationship between positive and negative values of P and the charging and discharging may be temporarily specified as needed.

At S2, if P>0, it is determined that the energy storage system performs charging. The MC determines optimal charging power $p_i$ and maximum charging power $pmax_i$ of each battery cell according to the situation of $SOC_i$ of each battery cell, and calculates the total optimal charging power $p_{total} = \sum_{i=1}^{n} p_i$ and the total maximum charging power $pmax_{total} = \sum_{i=1}^{n} pmax_i$. If $p_{total}$>P, that is, the total optimal charging power is greater than the microgrid power P, then the charging power of each energy storage subunit is ($p_i$*P/$p_{total}$), thereby ensuring that actual charging power of each battery cell may approach the optimal charging power $p_i$ while meeting the power demand of the microgrid.

At S3, in a case where $pmax_{total}$>P>$P_{total}$, the actual charging power of each energy storage subunit may be ($p_i$*P/$pmax_{total}$), it is ensured that the charging power of each battery cell can approach the optimal charging power $p_i$ while meeting the power demand of the microgrid. If P>$pmax_{total}$, the actual charging power of each energy storage subunit is p=$pmax_i$. At this time, each battery cell can exert the maximum power input capacity in the current SOC state.

At S4, if P<0, it is determined that the energy storage system performs discharging. The MC determines the optimal discharging power $p'_i$ and the maximum discharging power $pmax'_i$ of each battery cell according to the situation of $SOC_i$ of each battery cell and a power curve, and calculates the total optimal discharging power $p'_{total}$ and the total maximum discharging power $p'_{total} = \sum_{i=1}^{n} p'_i$ of each battery cell and a total SOC $SOC_{total} = \sum_{i=1}^{n} SOC_i$ of each battery cell.

If $p'_{total}$>P, that is, the total optimal discharging power is greater than the microgrid power P, then output power of each battery cell is P*($SOC_i$/$SOC_{total}$), ensuring that while meeting the power demand of the microgrid, the discharging power of each battery cell may be allocated according to the size of the SOC, that is, the battery cell with a high SOC discharges more, and the battery cell with a low SOC discharges less, thereby ensuring that each battery cell can be fully discharged at the same time to avoid power mutation.

At S5, $pmax'_{total}$>P>$P'_{total}$, then the output power of each energy storage subunit is ($p'_i$*p/$pmax'_{total}$), ensuring that while meeting the power demand of the microgrid, the discharging power of each battery cell can approach the optimal discharging power $p_i$. If P is greater than $pmax'_{total}$, the actual discharging power of each battery cell is $pmax'_i$, at this time, each battery cell can exert the maximum power output capacity in the current SOC state.

It is to be noted that, for simple description, each of the abovementioned method embodiments is expressed as a combination of a series of operations, but those skilled in the art should know that the present disclosure is not limited to the described operation sequence because some steps may be executed in other sequences or at the same time according to the present disclosure. Second, those skilled in the art should also know that all the embodiments described in the specification are optional embodiments and involved operations and modules are not always required by the present disclosure.

Through the above description of implementations, those skilled in the art may clearly know that the power control method according to the above embodiments may be implemented by means of software plus a necessary common hardware platform, certainly by means of hardware; but in many cases, the former is the better implementation. Based on such understanding, the technical solution of the present disclosure, which is essential or contributes to the conventional art, may be embodied in the form of a software product. The computer software product is stored in a storage medium (such as a Read-Only Memory (ROM)/RAM, a magnetic disk and an optical disc), including a number of instructions for causing a terminal device (which may be a mobile phone, a computer, a server, or a network device, etc.) to perform the methods described in various embodiments of the present disclosure.

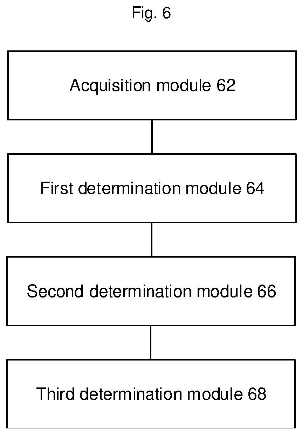

According to the embodiments of the present disclosure, a power control apparatus for implementing the above power control method is further provided. Fig. 6 is a structural block diagram of a power control apparatus according to an embodiment of the present disclosure. As shown in Fig. 6, the power control apparatus includes: an acquisition module 62, a first determination module 64, a second determination module 66, and a third determination module 68. The power control apparatus will be described below.

The acquisition module 62 is configured to acquire an SOC of each of a plurality of battery cells in an energy storage system, and a power direction and a power level of a microgrid connected to the energy storage system, wherein the power direction of the microgrid includes a charging direction or a discharging direction.

The first determination module 64 is connected to the above acquisition module 62, and is configured to determine, according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid.

The second determination module 66 is connected to the above first determination module 64, and is configured to determine a total optimal power and a total maximum power of the plurality of battery cells according to the optimal cell power of each of the plurality of battery cells and the maximum cell power of each of the plurality of battery cells.

The third determination module 68 is connected to the above second determination module 66, and is configured to determine the actual cell power of each of the plurality of battery cells according to the total optimal power and the total maximum power of the plurality of battery cells, and the power level of the microgrid.

It is to be noted herein that the above acquisition module 62, the first determination module 64, the second determination module 66, and the third determination module 68 correspond to S202 to S208 in the embodiment, and a plurality of modules are the same as the examples and application scenarios implemented by the corresponding steps, but are not limited to the contents disclosed in the above embodiment. It is to be noted that the above modules may run in a computer terminal 10 provided in the embodiment as part of the apparatus.

The embodiments of the present disclosure may provide a computer device. As at least one alternative embodiment, the above computer device may be located in at least one network device among a plurality of network devices of a computer network in this embodiment. The computer device includes a memory and a processor.

Herein, the memory may be configured to store a software program and a module, such as a program instruction/module corresponding to the power control method and apparatus in the embodiment of the present disclosure, and the processor performs various functional applications and data processing by running the software program and the module stored in the memory, that is, implements the above power control method. The memory may include a high speed RAM and may also include a nonvolatile memory such as one or more magnetic storage apparatuses, a flash memory, or other nonvolatile solid state memories. In some examples, the memory may further include memories remotely located relative to the processor, which may be connected to the computer terminal through a network. Examples of the above network include, but are not limited to, the Internet, the Intranet, a local area network, a mobile communication network, and a combination thereof.

The processor may call the information and application programs stored in the memory through a transmission apparatus to execute the following steps: acquiring the SOC of each of a plurality of battery cells in an energy storage system, and a power direction and a power level of a microgrid connected to the energy storage system, wherein the power direction of the microgrid includes a charging direction or a discharging direction; determining, according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid; determining a total optimal power and a total maximum power of each of the plurality of battery cells according to the optimal cell power of each of the plurality of battery cells and the maximum cell power of each of the plurality of battery cells; and determining the actual cell power of each of the plurality of battery cells according to the total optimal power and the total maximum power of the plurality of battery cells, and the power level of the microgrid.

Those of ordinary skill in the art should know that all or part of the steps in various methods of the above embodiment may be implemented by terminal device related hardware instructed through a program, the program may be stored in a nonvolatile storage medium, and the storage program includes: a flash disk, an ROM, an RAM, a magnetic disk or a compact disc.

The embodiments of the present disclosure further provide a nonvolatile storage medium. As at least one alternative embodiment, in the embodiment, the above nonvolatile storage medium may be configured to store program codes executed by the power control method provided in the above embodiment.

As at least one alternative embodiment, in the embodiment, the above nonvolatile storage medium may be located in any one computer terminal in a computer terminal set in a computer network or in any one mobile terminal in a mobile terminal set.

As at least one alternative embodiment, in the embodiment, the nonvolatile storage medium is configured to store program codes for executing the following steps: acquiring the SOC of each of a plurality of battery cells in an energy storage system, and a power direction and a power level of a microgrid connected to the energy storage system, wherein the power direction of the microgrid includes a charging direction or a discharging direction; determining, according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid; determining a total optimal power and a total maximum power of each of the plurality of battery cells according to the optimal cell power of each of the plurality of battery cells and the maximum cell power of each of the plurality of battery cells; and determining the actual cell power of each of the plurality of battery cells according to the total optimal power and the total maximum power of the plurality of battery cells, and the power level of the microgrid.

The sequence numbers of the above embodiments of the present disclosure are adopted not to represent superiority-inferiority of the embodiments but only for description.

In the above embodiments of the present disclosure, the description of the embodiments has its own focus. For parts that are not described in detail in a certain embodiment, reference may be made to related descriptions of other embodiments.

In the several embodiments provided in the present disclosure, it should be understood that, the disclosed technical content may be implemented in other ways. The apparatus embodiments described above are merely illustrative. For example, the division of the units may be a logical function division, and there may be other divisions in actual implementation. For example, a plurality of units or components may be combined or integrated into another system, or some features may be ignored, or not implemented. In addition, the displayed or discussed mutual coupling or direct coupling or communication connection may be indirect coupling or communication connection through some interfaces, units or modules, and may be in electrical or other forms. The units described as separate components may or may not be physically separated.

The units described as separate components may or may not be physically separated. The components displayed as units may or may not be physical units, that is, the components may be located in one place, or may be distributed on the plurality of units. Part or all of the units may be selected according to actual requirements to achieve the purposes of the solutions of this embodiment.

In addition, the functional units in the various embodiments of the present disclosure may be integrated into one processing unit, or each unit may exist alone physically, or two or more than two units may be integrated into one unit. The above integrated unit may be implemented in the form of hardware, or may be implemented in the form of a software functional unit.

When being implemented in form of software functional unit and sold or used as an independent product, the integrated unit may be stored in the nonvolatile storage medium. Based on this understanding, the technical solutions of the present disclosure essentially or the parts that contribute to the prior art, or all or part of the technical solutions may be embodied in the form of a software product. The computer software product is stored in a storage medium, including a plurality of instructions for causing a computer device (which may be a personal computer, a server, or a network device, and the like) to execute all or part of the steps the method described in the various embodiments of the present disclosure. The abovementioned storage medium includes a USB flash disk, an ROM, an RAM, and various media that may store program codes, such as a mobile hard disk, a magnetic disk, or an optical disk.

The above description is merely preferred implementation of the present disclosure, and it is to be noted that those of ordinary skill in the art may also make several improvements and refinements without departing from the principle of the present disclosure, and it should be considered that these improvements and refinements shall all fall within the scope of protection of the present disclosure.

**Industrial Applicability**

Solutions provided in embodiments of the present disclosure may be applied to the field of battery energy storage. In the embodiments of the present disclosure, a method of reasonably estimating a total optimal power and a total maximum power of a plurality of battery cells in an energy storage system is used. By determining the actual cell power of each of the plurality of battery cells according to the total optimal power and the total maximum power of the plurality of battery cells, and a power level of a microgrid, the technical effect of improving the intelligent level of power distribution between each battery cell in the energy storage system and a microgrid during charging and discharging is achieved.

## Claims

1. A power control method, comprising:

   acquiring a State of Charge (SOC) of each of a plurality of battery cells in an energy storage system, and a power direction and a power level of a microgrid connected to the energy storage system, wherein the power direction of the microgrid comprises a charging direction or a discharging direction;
   determining, according to the SOC of each of the plurality of battery cells and the power direction of the microgrid, an optimal cell power of each of the plurality of battery cells matching the power direction of the microgrid, and a maximum cell power of each of the plurality of battery cells matching the power direction of the microgrid;
   determining a total optimal power and a total maximum power of the plurality of battery cells according to the optimal cell power of each of the plurality of battery cells and the maximum cell power of each of the plurality of battery cells; and
   determining an actual cell power of each of the plurality of battery cells according to the total optimal power and the total maximum power of the plurality of battery cells, and the power level of the microgrid.

2. The method as claimed in claim 1, wherein determining, according to the SOC of each of the plurality of battery cells and the power direction of the microgrid, the optimal cell power of each of the plurality of battery cells matching the power direction of the microgrid, and the maximum cell power of each of the plurality of battery cells matching the power direction of the microgrid comprises:

   in a case where the power direction of the microgrid is that the microgrid delivers electric energy to the energy storage system, calling an optimal charging power curve of each of the plurality of battery cells and a maximum charging power curve of each of the plurality of battery cells;
   determining an optimal charging power of each of the plurality of battery cells and a maximum charging power of each of the plurality of battery cells, according to the optimal charging power curve of each of the plurality of battery cells, the maximum charging power curve of each of the plurality of battery cells, and the SOC of each of the plurality of battery cells, wherein the optimal cell power comprises the optimal charging power, and the maximum cell power comprises the maximum charging power;
   in a case where the power direction of the microgrid is that the energy storage system delivers the electric energy to the microgrid, calling an optimal discharging power curve of each of the plurality of battery cells and a maximum discharging power curve of each of the plurality of battery cells; and
   determining an optimal discharging power of each of the plurality of battery cells and a maximum discharging power of each of the plurality of battery cells, according to the optimal discharging power curve of each of the plurality of battery cells, the maximum discharging power curve of each of the plurality of battery cells, and the SOC of each of the plurality of battery cells, wherein the optimal cell power comprises the optimal discharging power, and the maximum cell power comprises the maximum discharging power.

3. The method as claimed in claim 2, wherein, in a case where the power direction of the microgrid is that the microgrid delivers the electric energy to the energy storage system, determining the actual cell power of each of the plurality of battery cells according to the total optimal power and the total maximum power of the plurality of battery cells, and the power level of the microgrid comprises:

   in a case where the power level of the microgrid is less than the total optimal charging power of the plurality of battery cells, dividing the power level of the microgrid by the total optimal charging power of the plurality of battery cells to obtain a first ratio, wherein the total optimal charging power of the plurality of battery cells is the sum of the optimal charging power of each of the plurality of battery cells; and
   multiplying the optimal charging power of each of the plurality of battery cells by the first ratio to obtain the actual cell power each of the plurality of battery cells.

4. The method as claimed in claim 3, wherein, in a case where the power level of the microgrid is greater than the total optimal charging power of the plurality of battery cells and less than the total maximum charging power of the plurality of battery cells, dividing the power level of the microgrid by the total maximum charging power of the plurality of battery cells to obtain a second ratio, wherein the total maximum charging power of the plurality of battery cells is the sum of the maximum charging power of each of the plurality of battery cells;

   multiplying the optimal charging power of each of the plurality of battery cells by the second ratio to obtain the actual cell power of each of the plurality of battery cells; and
   in a case where the power level of the microgrid is greater than the total maximum charging power of the plurality of battery cells, taking the maximum charging power of each of the plurality of battery cells as the actual cell power of each of the plurality of battery cells.

5. The method as claimed in claim 2, wherein, in a case where the power direction of the microgrid is that the energy storage system delivers the electric energy to the microgrid, the determining the actual cell power of each of the plurality of battery cells according to the total optimal power and the total maximum power of the plurality of battery cells, and the power level of the microgrid comprises:

> determining a total SOC of the plurality of battery cells according to the SOC of each of the plurality of battery cells;
> in a case where the power level of the microgrid is less than the total optimal discharging power of the plurality of battery cells, dividing the SOC of each of the plurality of battery cells by the total SOC of the plurality of battery cells to obtain a third ratio, wherein the total optimal discharging power of the plurality of battery cells is the sum of the optimal discharging power of each of the plurality of battery cells; and
> multiplying the power level of the microgrid by the third ratio to obtain the actual cell power of each of the plurality of battery cells.

6. The method as claimed in claim 5, wherein, in a case where the power level of the microgrid is greater than the total optimal discharging power of the plurality of battery cells and less than the total maximum discharging power of the plurality of battery cells, dividing the power level of the microgrid by the total maximum discharging power of the plurality of battery cells to obtain a fourth ratio, wherein the total maximum discharging power of the plurality of battery cells is the sum of the maximum discharging power of each of the plurality of battery cells;

> Multiplying the optimal discharging power of each of the plurality of battery cells by the fourth ratio to obtain the actual cell power of each of the plurality of battery cells; and
> in a case where the power level of the microgrid is greater than the total maximum discharging power of the plurality of battery cells, taking the maximum discharging power of each of the plurality of battery cells as the actual cell power of each of the plurality of battery cells.

7. A power control apparatus, comprising:

> an acquisition module, configured to acquire a State of Charge (SOC) of each of a plurality of battery cells in an energy storage system, and a power direction and a power level of a microgrid connected to the energy storage system, wherein the power direction of the microgrid comprises a charging direction or a discharging direction; a first determination module, configured to determine, according to the SOC of the plurality of battery cells and the power direction of the microgrid, an optimal cell power of each of the plurality of battery cells matching the power direction of the microgrid, and a maximum cell power of each of the plurality of battery cells matching the power direction of the microgrid,; a second determination module, configured to determine a total optimal power and a total maximum power of the plurality of battery cells according to the optimal cell power of each of the plurality of battery cells and the maximum cell power of each of the plurality of battery cells; and a third determination module, configured to determine an actual cell power of each of the plurality of battery cells according to the total optimal power and the total maximum power of the plurality of battery cells, and the power level of the microgrid.

8. An energy storage system, comprising: a Microgrid Controller (MC), a plurality of energy storage units, and an electric meter, wherein one end of the electric meter is connected to a microgrid, and the other end is connected to the MC to inform the MC of a power direction and a power level of the microgrid; each of the plurality of energy storage units comprises a battery cell, a Battery Management System (BMS), and a Power Conversion System (PCS); and the MC is configured to perform the power control method according to any one of claims 1 to 6 to control the actual cell power of each of the plurality of battery cells comprised in the plurality of energy storage units.

9. A nonvolatile storage medium, comprising a stored program, wherein the program, when running, controls a device where the nonvolatile storage medium is located to perform the power control method according to any one of claims 1 to 6.

10. A computer device, comprising a memory and a processor, wherein the memory is configured to store a program, the processor is configured to run the program stored in the memory, and the program, when running, performs the power control method according to any one of claims 1 to 6.

Fig. 1

Computer terminal 10

Processor 102a

Processor 102b

......

Processor 102n

Bus

Memory 104

Program instruction

Data storage device

Network interface

Input/output interface

Wired and/or wireless network connection

Cursor control apparatus

Keyboard

Display

Fig. 2

A SOC of each of a plurality of battery cells in an energy storage system, and a power direction and a power level of a microgrid connected to the energy storage system are acquired, wherein the power direction of the microgrid includes a charging direction or a discharging direction

S202

An optimal cell power of each of the plurality of battery cells matching the power direction of the microgrid, and a maximum cell power of each of the plurality of battery cells matching the power direction of the microgrid are determined according to the SOC of each of the plurality of battery cells and the power direction of the microgrid

S204

A total optimal power and a total maximum power of the plurality of battery cells are determined according to the optimal cell power of each of the plurality of battery cells and the maximum cell power of each of the plurality of battery cells

S206

An actual cell power of each of the plurality of battery cells is determined according to the total optimal power and the total maximum power of the plurality of battery cells, and the power level of the microgrid

S208

Fig. 3

Energy storage system 30

Microgrid Controller (MC) 31

Energy storage unit 32

Electric meter 33

Fig. 4

Microgrid Controller (MC) 31

TCP

TCP

TCP

TCP

TCP

TCP

RS485

Battery Management System (BMS) #1

Power Conversion System (PCS) #1

...

Battery Management System (BMS) #n

Power Conversion System (PCS) #n

Photovoltaic inverter

Electric meter 33

Electric meter 33

Energy storage container

Energy storage container

Load

Power grid

# EP 4 636 981 A1

## Fig. 5

Start an MC, acquire battery level information of each energy storage unit through a BMC, and collecting a power level and direction of an energy storage grid-connected point through an electric meter

Mircrogrid power>0

According to the range of $SOC_i$, determine optimal charging power

According to the range of $SOC_i$, determine optimal discharging power

$0 \leq SOC < 5\%$ — Optimal power pi=a Maximum power pmax=A

$5\% \leq SOC < 20\%$ — Optimal power pi=b Maximum power pmax=B

$20\% \leq SOC < 30\%$ — Optimal power pi=c Maximum power pmax=C

...

$80\% \leq SOC < 90\%$ — Optimal power pi=f Maximum power pmax=F

$90\% \leq SOC < 100\%$ — Optimal power pi=g Maximum power pmax=G

$0 \leq SOC < 5\%$ — Optimal power p'i=a Maximum power pmax'i=A

$5\% \leq SOC < 20\%$ — Optimal power p'i=b Maximum power pmax'i=B

$20\% \leq SOC < 30\%$ — Optimal power p'i=c Maximum power pmax'i=C

...

$80\% \leq SOC < 90\%$ — Optimal power p'i=f Maximum power pmax'i=F

$90\% \leq SOC < 100\%$ — Optimal power p'i=g Maximum power pmax'i=G

Optimal charging power of each energy storage unit

Optimal discharging power of each energy storage unit

Calculate: $p_{total}$ and $pmax_{total}$

Calculate: $p'_{total}$, $SOC_{total}$, and $pmax'_{total}$

$p_{total} > P$ — N / Y

$p'_{total} > P$ — N / Y

$pmax_{total} > P > P_{total}$ — N / Y

$pmax'_{total} > P > P'_{total}$ — N / Y

Output power of each energy storage unit: $pmax_i$

Output power of each energy storage unit: $p_i*P/pmax_{total}$

Output power of each energy storage unit: $pi*P/ptotal$

Output power of each energy storage unit: $pmax'$

Output power of each energy storage unit: $p'_i*P/pmax'_{total}$

Output power of each energy storage unit: $P*(SOC_i/SOC_{total})$

Fig. 6

```
┌─────────────────────────────────────────┐
│                                         │
│         Acquisition module 62           │
│                                         │
└─────────────────────────────────────────┘
                    │
┌─────────────────────────────────────────┐
│                                         │
│       First determination module 64     │
│                                         │
└─────────────────────────────────────────┘
                    │
┌─────────────────────────────────────────┐
│                                         │
│      Second determination module 66     │
│                                         │
└─────────────────────────────────────────┘
                    │
┌─────────────────────────────────────────┐
│                                         │
│       Third determination module 68     │
│                                         │
└─────────────────────────────────────────┘
```

## INTERNATIONAL SEARCH REPORT

| International application No. |
|---|
| **PCT/CN2023/113178** |

### A. CLASSIFICATION OF SUBJECT MATTER

H02J7/00(2006.01)i

According to International Patent Classification (IPC) or to both national classification and IPC

### B. FIELDS SEARCHED

Minimum documentation searched (classification system followed by classification symbols)

IPC:H02J

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 功率控制, 最大, 功率, 充电功率, 放电功率, 最佳, 最优, 实际功率, 功率曲线, 剩余电量, 单个电池, 单电池, 微电网, 储能, power control, maximum, optimal, actual, power, charge power, discharge power, power curve, residual electric quantity, single battery, micro-grid, energy storage

### C. DOCUMENTS CONSIDERED TO BE RELEVANT

| Category* | Citation of document, with indication, where appropriate, of the relevant passages | Relevant to claim No. |
|---|---|---|
| PX | CN 116316984 A (HEFEI GUOXUAN HIGH-TECH POWER ENERGY CO., LTD.) 23 June 2023 (2023-06-23)<br>claims 1-10 | 1-10 |
| A | CN 110401217 A (TBEA XI'AN ELECTRIC TECHNOLOGY CO., LTD.; TBEA XINJIANG SUNOASIS CO., LTD.) 01 November 2019 (2019-11-01)<br>description, paragraphs 0042-0086, and figures 1-5 | 1-10 |
| A | CN 112234639 A (JIANGSU HUIZHI ENERGY ENGINEERING TECHNOLOGY INNOVATION RESEARCH INSTITUTE CO., LTD.) 15 January 2021 (2021-01-15)<br>description, paragraphs 0019-0032, and figures 1-3 | 1-10 |
| A | CN 103647274 A (CHINA XD ELECTRIC CO., LTD.; XI'AN HIGH VOLTAGE APPARATUS RESEARCH INSTITUTE CO., LTD.) 19 March 2014 (2014-03-19)<br>entire document | 1-10 |
| A | CN 112165109 A (STATE GRID JIANGSU COMPREHENSIVE ENERGY SERVICE CO., LTD.) 01 January 2021 (2021-01-01)<br>entire document | 1-10 |

☑ Further documents are listed in the continuation of Box C.    ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 November 2023** | **22 November 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/113178**

### C.    DOCUMENTS CONSIDERED TO BE RELEVANT

| Category* | Citation of document, with indication, where appropriate, of the relevant passages | Relevant to claim No. |
|---|---|---|
| A | CN 114759651 A (BEIJING HYPERSTRONG TECHNOLOGY CO., LTD.) 15 July 2022 (2022-07-15) <br> entire document | 1-10 |
| A | US 2018269689 A1 (ROLLS ROYCE CORP.; ROLLS ROYCE NORTH AMERICAN TECHNOLOGIES INC.) 20 September 2018 (2018-09-20) <br> entire document | 1-10 |

Form PCT/ISA/210 (second sheet) (July 2022)

**INTERNATIONAL SEARCH REPORT**
Information on patent family members

International application No.

**PCT/CN2023/113178**

| Patent document cited in search report | | | Publication date (day/month/year) | Patent family member(s) | | | Publication date (day/month/year) |
|---|---|---|---|---|---|---|---|
| CN | 116316984 | A | 23 June 2023 | None | | | |
| CN | 110401217 | A | 01 November 2019 | None | | | |
| CN | 112234639 | A | 15 January 2021 | None | | | |
| CN | 103647274 | A | 19 March 2014 | None | | | |
| CN | 112165109 | A | 01 January 2021 | CN | 112165109 | B | 18 October 2022 |
| CN | 114759651 | A | 15 July 2022 | None | | | |
| US | 2018269689 | A1 | 20 September 2018 | US | 10530163 | B2 | 07 January 2020 |
| | | | | CA | 2992339 | A1 | 17 September 2018 |
| | | | | EP | 3376631 | A1 | 19 September 2018 |
| | | | | EP | 3376631 | B1 | 17 June 2020 |

Form PCT/ISA/210 (patent family annex) (July 2022)

**EP 4 636 981 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023102805964

- CN 202011322379X